Europäisches Patentamt

(19) European Patent Office

Office européen des brevets

(11) Numéro de publication : **0 051 820**
**B1**

(12) **FASCICULE DE BREVET EUROPÉEN**

(45) Date de publication du fascicule du brevet :
03.04.85

(21) Numéro de dépôt : **81109205.5**

(22) Date de dépôt : **29.10.81**

(51) Int. Cl.⁴ : **G 01 R 15/06**

(54) **Dispositif pour l'élimination rapide des charges piégées dans un pont diviseur capacitif utilisé pour la surveillance des tensions alternatives élevées.**

(30) Priorité : **06.11.80 FR 8023700**

(43) Date de publication de la demande :
**19.05.82 Bulletin 82/20**

(45) Mention de la délivrance du brevet :
**03.04.85 Bulletin 85/14**

(84) Etats contractants désignés :
**BE CH DE FR LI SE**

(56) Documents cités :
**DE-A- 2 634 595**
**FR-A- 2 406 828**

(73) Titulaire : **ALSTHOM-ATLANTIQUE Société anonyme dite:**
**38, Avenue Kléber**
**F-75784 Paris Cedex 16 (FR)**

(72) Inventeur : **Dupraz, Jean-Pierre**
**7, Rue de la Paix**
**F-73100 Aix-les-Bains (FR)**

(74) Mandataire : **Weinmiller, Jürgen et al**
**Zeppelinstrasse 63**
**D-8000 München 80 (DE)**

Jouve, 18, rue St-Denis, 75001 Paris, France

# 0 051 820

**Description**

La présente invention concerne la surveillance des tensions alternatives élevées notamment celles des lignes d'énergie électrique haute tension.

La surveillance d'une tension alternative élevée, telle que celle d'une ligne d'énergie électrique haute tension se fait par l'intermédiaire d'un signal de mesure délivré par un réducteur de tension qui, pour des raisons de coût, est un pont diviseur capacitif constitué d'une colonne capacitive soumise à la quasi-totalité de la tension élevée et d'une capacité de base ne supportant qu'une faible tension et délivrant le signal de mesure. Ce dernier, lorsqu'il est extrait par une sonde présentant une impédance d'entrée plusieurs dizaines de fois supérieure à celle de la capacité de base reproduit fidèlement la forme de la tension alternative élevée, sauf dans certaines configurations où les charges piégées dans le pont diviseur capacitif provoquent des sautes de tension. Ces charges piégées sont dues aux différences entre les constantes de temps de décharge de la colonne capacitive et de la capacité de base. Lors d'une coupure de la tension alternative élevée, des charges de même valeur restent emprisonnées dans la colonne capacitive et dans la capacité de base mais elles décroissent à des vitesses très différentes et deviennent rapidement inégales. Si la tension élevée n'est pas rétablie immédiatement ou après que ces charges aient entièrement disparu, leur différence provoque l'apparition sur le condensateur de base d'une tension continue qui décroît lentement, la capacité de base étant toujours chargée par une forte impédance et ayant une constante de décharge de quelques dizaines de secondes.

Sans précaution spéciale, cette tension d'erreur sature l'appareillage de surveillance recevant le signal de mesure et le rend inopérant. Il est connu de protéger un appareillage de surveillance en intercalant entre ce dernier et le pont diviseur capacitif un filtre sélectif centré sur la fréquence de la tension élevée, cela chaque fois que des charges piégées sont susceptibles de se manifester c'est-à-dire pendant un temps appréciable au début de certaines remises sous tension.

Ce filtre présente cependant l'inconvénient de filtrer également le signal de mesure et de le rendre imprécis pendant la quelque centaine de secondes où il est intercalé.

Il est également connu de prévoir une impédance de fuite connectée en parallèle sur la capacité de base (voir DE-A 2634595 et FR-A 2406828). Selon DE-A 2634595 cette impédance de fuite peut être reliée à la capacité de base par l'intermédiaire d'un pont redresseur. De plus, il est connu de FR-A 2406828 de ne connecter l'impédance de fuite que lorsque les charges piégées sont susceptibles de se manifester.

La présente invention a pour but de limiter les inconvénients dus aux charges piégées en permettant à celles-ci de s'éliminer très rapidement sans trop perturber le signal de mesure.

Elle a pour objet un dispositif pour l'élimination des charges piégées dans un pont diviseur capacitif utilisé pour le contrôle d'une tension alternative élevée et formé d'une colonne capacitive soumise à la quasi totalité de la tension alternative élevée et d'une capacité de base placée en série ne supportant qu'une faible tension ledit dispositif comportant une impédance de fuite connectée en parallèle sur la capacité de base. Ce dispositif est caractérisé en ce que l'impédance de fuite comporte un pont redresseur à diodes connecté par ses bornes alternatives d'entrée en parallèle sur la capacité de base, et deux enroulements identiques connectés chacun en parallèle sur une diode du pont, les deux diodes shuntées par les enroulements étant directement raccordées à une même borne alternative du pont.

Le dispositif selon l'invention est avantageusement complété par un interrupteur commandé intercalé en série avec le pont redresseur aux bornes de la capacité de base, fermé après une coupure de la tension élevée durant plus de quelques secondes et ouvert peu de temps après le rétablissement de la tension élevée, ledit interrupteur commandé étant contrôlé par un circuit temporisateur excité par un détecteur de tension alternative connecté aux bornes de la capacité de base.

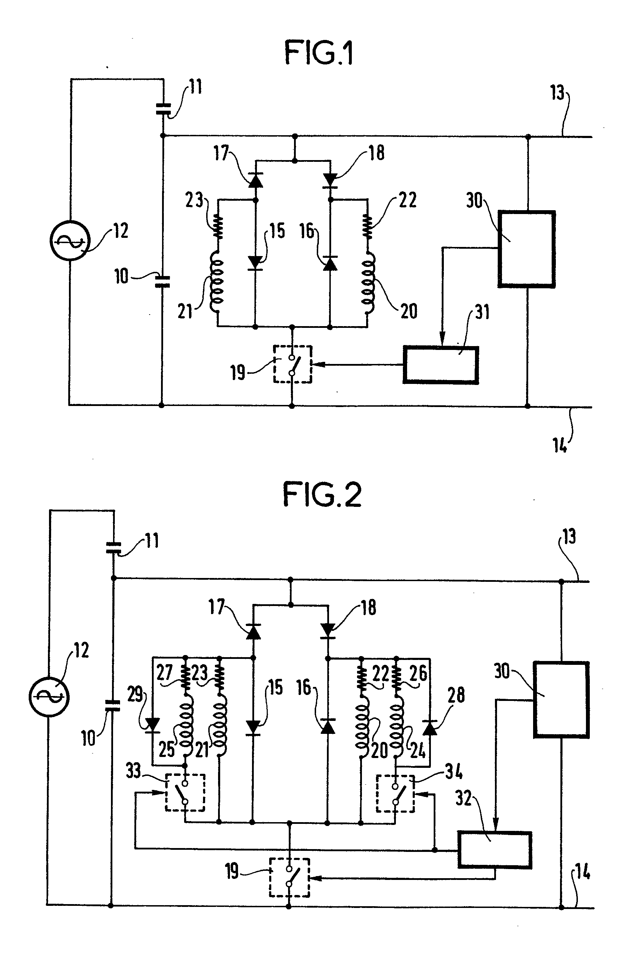

D'autres caractéristiques et avantages de l'invention ressortiront des revendications jointes et de la description ci-après de plusieurs modes de réalisation donnés à titre d'exemple. Cette description sera faite en regard des figures 1 et 2 du dessin qui représentent des schémas électriques de deux dispositifs selon l'invention.

On distingue sur la figure 1 un pont diviseur capacitif schématisé par deux condensateurs 10 et 11 connectés en série, l'un 10 représentant sa capacité de base et l'autre 11 sa colonne capacitive. Ce pont diviseur est connecté par ses extrémités aux bornes d'une source électrique 12 délivrant la haute tension alternative à surveiller et fournit aux bornes 13, 14 de sa capacité de base 10 un signal de mesure sensé reproduire sous une faible tension la forme de la tension alternative élevée à surveiller. Le dispositif selon l'invention est connecté entre les bornes 13, 14 de la capacité de base 10. Il comporte un pont redresseur à diodes 15, 16, 17, 18 connecté en série, par ses bornes alternatives, avec un interrupteur commandé 19. Deux enroulements identiques schématisés par une inductance 20 respectivement 21 connectée en série avec une résistance 22 respectivement 23 sont placés en parallèle l'un sur la diode 16, l'autre sur la diode 15 qui toutes deux sont reliées directement à une même borne alternative du pont redresseur. L'interrupteur commandé est contrôlé par un circuit temporisateur 31 excité par un circuit détecteur de tension alternative 30 connecté entre les bornes 13 et 14 de la capacité de base 10.

L'interrupteur commandé 19 n'est pas obligatoire et peut être remplacé par un shunt. Il permet de ne connecter le pont redresseur et ses enroulements que lorsque les charges piégées sont susceptibles de se manifester et pour la durée de leur élimination.

Comme on l'a vu précédemment, les charges piégées ne se manifestent, lors d'un rétablissement de la tension alternative élevée, qu'après une coupure ayant duré plus de quelques secondes. C'est pourquoi il suffit de fermer l'interrupteur commandé 19 après toutes coupures de la tension élevée dépassant plus de quelques secondes et de l'ouvrir avec un retard sur le rétablissement de la tension alternative élevée, ce retard étant de l'ordre de la centaine de millisecondes, durée qui comme on le verra par la suite suffit au dispositif selon l'invention pour éliminer les charges piégées. Le détecteur de tension alternative 30 est un circuit classique qui délivre en sortie un signal binaire dont le niveau correspond à la présence ou à l'absence entre les bornes 13, 14 d'une tension alternative ayant une amplitude supérieure à un seuil donné. Le circuit temporisateur 31 présente une double temporisation, une première temporisation ne transmettant un ordre de fermeture de l'interrupteur commandé 19 qu'après une détection d'une coupure de tension alternative élevée supérieure à quelques secondes par exemple cinq et une deuxième temporisation ne transmettant un ordre d'ouverture de l'interrupteur commandé 19 qu'une centaine de millisecondes après la détection d'un rétablissement de la tension alternative élevée. Les circuits réalisant ces deux temporisations ne seront pas décrits car ils font partie de la technique courante. L'interrupteur commandé 19 est avantageusement un simple relais mécanique classique en raison de ses qualités d'isolement lorsqu'il est ouvert et de sa faible résistance lorsqu'il est fermé, la vitesse de commutation n'ayant pas d'importance dans le cas présent.

Le dispositif comporte deux branches de structures semblables, à l'exception du sens des diodes, réunies par l'interrupteur commandé 19 en parallèle sur les bornes 13, 14 de la capacité de base 10, l'une constituée des éléments 16, 18, 20, 22 assurant l'écoulement des charges piégées tendant à rendre la borne 13 du condensateur de base 10 positive par rapport à sa borne 14 et l'autre constituée des éléments 15, 17, 21, 23 assurant l'écoulement des charges piégées tendant à rendre la borne 13 du condensateur de base 10 négative par rapport à sa borne 14.

Les charges piégées tendant à rendre positive la borne 13 du condensateur de base 10 par rapport à sa borne 14 s'écoulent à travers l'inductance 20, la résistance 22 et la diode 18. La diode 16 permet un rebouclage de l'inductance 20 afin qu'elle dissipe son énergie dans la résistance 22 sans la transférer à la capacité de base 10. Elle empêche également le potentiel de la cathode de la diode 18 de descendre en dessous de celui de la borne 14 ce qui évite à cette dernière diode 18 de conduire lorsque le condensateur de base 10 a sa borne 13 négative par rapport à sa borne 14.

De la même façon, les charges piégées tendant à rendre négative la borne 13 du condensateur de base 10 par rapport à sa borne 14 s'écoulent à travers la diode 17, la résistance 23 et l'inductance 21. La diode 15 permet un rebouclage de l'inductance 21 afin qu'elle dissipe son énergie dans la résistance 23 sans la transférer à la capacité de base 10. Elle empêche également le potentiel de l'anode de la diode 17 de dépasser celui de la borne 14 ce qui évite à cette dernière diode de conduire lorsque le condensateur de base 10 à sa borne 13 positive par rapport à sa borne 14.

L'écoulement des charges piégées dépend du comportement du dispositif en régime transitoire, qui est assimilable, lorsque l'on néglige la tension de seuil des diodes à celui d'une inductance de même valeur L que les inductances 20 ou 21 connectée en série avec une résistance de même valeur R que les résistances 22 ou 23 aux bornes d'une capacité préalablement chargée, à la différence près que le courant de décharge de la capacité ne peut s'inverser après s'être annulé. Pour diminuer la durée d'écoulement des charges piégées il y a intérêt à faire intervenir la première annulation de courant le plus tôt possible c'est-à-dire à rendre la décharge oscillante. Pour cela il faut vérifier la condition bien connue :

$$R^2 < 4 \frac{L}{C} \tag{1}$$

C étant la valeur de la capacité de base. La durée du courant de décharge est alors :

$$\frac{1}{\sqrt{\dfrac{1}{LC} - \dfrac{R^2}{4L^2}}} \left( \frac{\pi}{2} + \text{Arc tg} \frac{1}{\sqrt{\dfrac{4L}{CR^2} - 1}} \right)$$

La perturbation apportée au signal de mesure par le dispositif dépend du courant que celui-ci soutire en régime permanent à la capacité de base 10 lorsque l'interrupteur commandé 19 est fermé. Pour l'apprécier, on peut calculer le courant traversant l'une des inductances 20 ou 21 du dispositif lorsqu'il est soumis à une tension alternative. On s'intéresse par exemple à l'inductance 20 et l'on suppose que la borne 13 du condensateur de base 10 est portée, par rapport à la borne 14 à un potentiel alternatif V sin wt.

Pendant les intervalles de temps (0, π/w) à 2 Kπ près la branche du dispositif formée des éléments 16, 18, 20, 22 sera en excitation forcée, sa diode 18 étant polarisée dans le sens passant et sa diode 16 bloquée. Pendant les intervalles de temps restant ($\pi/w$, $2\,\pi/w$) à $2\,K\pi$ près elle sera en amortissement libre sa diode 18 étant bloquée.

Le courant $i(t)$ traversant l'inductance 20 pendant les instants (0, $\pi/w$) à $2\,K\pi$ près où la branche formée des éléments 16, 18, 20, 22 est en excitation forcée vérifie l'équation différentielle :

$$Ri + L\frac{di}{dt} = V \sin wt$$

qui a pour solution générale :

$$i(t) = i_{10} \exp\left(-\frac{R}{L}t\right) + i_p \sin \varphi \exp\left(-\frac{R}{L}t\right) + i_p \sin (wt + \varphi)$$

avec

$$i_p = \frac{V}{\sqrt{R^2 + L^2\,w^2}} \qquad \varphi = \text{Arc tg}\,\frac{Lw}{R}$$

$i_{10}$ étant la valeur du courant aux instants $t = 0 + 2\,K$

Le courant $i(t)$ traversant l'inductance 20 pendant les intervalles de temps ($\pi/w$, $2\,\pi/w$) à $2\,K\pi$ près où la branche formée des éléments 16, 18, 20, 22 est en amortissement libre vérifie l'équation différentielle :

$$Ri + L\frac{di}{dt} = 0$$

qui a pour solution générale :

$$i(t) = i_{11} \exp\left(-\frac{Rt}{L}\right)$$

$i_{11}$ étant le courant aux instants $t = \pi/w + 2\,K\pi$.

En régime permanent le courant dans l'inductance 20 a même valeur à la fin d'une période d'excitation forcée ou au début d'une période d'amortissement libre ce qui permet d'écrire :

$$i_{10} = i_{11} \exp\left(-\frac{R\pi}{Lw}\right)$$

et par conséquent de déterminer complètement le courant traversant l'inductance 20 pendant les périodes d'excitation forcée.

$$i(t) = \frac{V}{\sqrt{R^2 + L^2\,w^2}}\left[\sin (wt - \varphi) + \sin \varphi\,\frac{\exp\left(-\frac{R}{L}t\right)}{1 - \exp\left(-\frac{R\pi}{Lw}\right)}\right]$$

Ce courant est celui dérivé de la source de tension $V \sin wt$ par le dispositif pendant les intervalles de temps (0, $\pi/w$) à $2\,K\pi$ près car pendant ces instants la diode 17 en série dans l'autre branche est bloquée.

Le courant dérivé de la source de tension $V \sin wt$ par le dispositif pendant les instants ($\pi/w$, $2\,\pi/w$) à $2\,k\pi$ près est dû à l'autre branche et se déduit du courant traversant l'inductance 20 par un raisonnement analogue au précédent en tenant compte de l'inversion du sens du courant et du retard de $\pi/w$

$$i(t) = -\frac{V}{\sqrt{R^2 + L^2\,w^2}}\left[\sin (wt - \varphi - \pi) + \sin \varphi\,\frac{\exp\left(-\frac{R}{L}t + \frac{R\pi}{Lw}\right)}{1 - \exp\left(-\frac{R\pi}{Lw}\right)}\right]$$

Le courant dérivé de la source de tension est égal à la somme de ces courants et a pour expression :

$$i(t) = \frac{V}{\sqrt{R^2 + L^2\,w^2}}\left[\sin (wt - \varphi) + (-1)^n \sin \varphi\,\frac{\exp\left(-\frac{R}{L}t_1\right)}{1 - \exp\left(-\frac{R\pi}{Lw}\right)}\right]$$

avec $t = t_1$ modulo $\pi/w$ et $n = w/\pi \times (t - t_1)$.

Ce courant peut être décomposé en deux parties une première partie :

$$i_A(t) = \frac{V}{\sqrt{R^2 + L^2 w^2}} \sin (wt - \varphi)$$

qui est le courant dérivé de la source de tension par une inductance de valeur L en série avec une résistance de valeur R, et une deuxième partie :

$$i_B(t) = \frac{V}{\sqrt{R^2 + L^2 w^2}} \sin \varphi \frac{\exp\left(-\dfrac{R}{L} t_1\right)}{1 - \exp\left(-\dfrac{R\pi}{Lw}\right)}$$

qui est un courant pulsatoire.

On remarquera que la composante de courant $i_B$, dans la mesure où elle se rapproche de la valeur :

$$\frac{V}{\sqrt{R^2 + L^2 w^2}} \sin \varphi$$

au début des alternances positives de la tension alternative V sin wt c'est-à-dire où :

$$\left| \frac{V}{R^2 + L^2 w^2} \sin \varphi \left( \frac{1}{1 - \exp\left(-\dfrac{R\pi}{Lw}\right)} - 1 \right) \right| < \varepsilon . I_p$$

et dans la mesure où elle devient négligeable après une demi alternance

$$\left| \frac{V}{\sqrt{R^2 + L^2 w^2}} \sin \varphi \frac{\exp\left(-\dfrac{R\pi}{Lw}\right)}{1 - \exp\left(-\dfrac{R\pi}{Lw}\right)} \right| < \varepsilon . I_p$$

peut être considérée comme une composante correctrice, présente pendant la première moitié des demi-alternances positives de la source de tension V sin wt, tendant à contrecarrer l'effet du déphasage de la composante de courant $i_A$. Dans ces conditions elles peut être négligée pour l'étude des perturbations au signal de mesure apportées par le dispositif en régime permanent.

La deuxième condition est incluse dans la première qui s'exprime en remplaçant sin $\varphi$ par sa valeur :

$$\frac{1}{\left(\dfrac{R^2}{L^2 w^2} + 1\right)^{1/2}} \cdot \frac{1}{\exp\left(+\dfrac{R\pi}{Lw}\right) - 1} < \varepsilon . \tag{2}$$

Cette condition se trouve facile à satisfaire dans la pratique. Il suffit pour cela de prendre la quantité R/Lw > 0,2. En effet pour la valeur R/Lw égal à 0,2 la condition devient :

$$1, 12 < \varepsilon .$$

Pour la valeur R/Lw égal à 1 elle devient :

$$0,03 < \varepsilon$$

et pour la valeur R/Lw égal à 5

$$2,9 \cdot 10^{-8} < \varepsilon .$$

En admettant la condition (2) vérifiée la perturbation en régime permanent apportée au signal de mesure par la présence du dispositif est inférieure à celle qu'apporterait le couplage en parallèle sur la capacité de base 10 d'une inductance de valeur L en série avec une résistance de valeur R.

En admettant que la capacité de base 10 a une valeur très grande devant celle de la capacité 11 et en appelant C la valeur de la capacité de base 10, l'erreur relative apportée par un tel couplage à l'amplitude de la tension du signal de mesure peut s'écrire :

$$\left| \frac{v'}{v} - 1 \right| = \left| \frac{1}{LCw^2 - 1 - jRCw} \right| = \frac{1}{\sqrt{(LCw^2 - 1)^2 + R^2 \, C^2 \, w^2}}$$

v étant la tension aux bornes de la capacité de base sans couplage et v' avec couplage.
En admettant que la condition

$$LCw^2 \gg 1 \tag{3}$$

est respectée cette erreur relative est peu différente de :

$$\left| \frac{v'}{v} - 1 \right| \# \frac{1}{Cw} \frac{1}{\sqrt{R^2 + L^2 \, w^2}} .$$

Elle est faible en raison même de la condition (3).
L'erreur relative faite sur la phase du signal de mesure en présence d'un tel couplage est égal à :

$$Arg \left( \frac{v'}{v} \right) = + \, Arc \, cotg \left[ \frac{Lw}{R} \, (LCw^2 - 1) + RCw \right]$$

En admettant la condition

$$LCw^2 \gg 1$$

$$Arg \left( \frac{v'}{v} \right) \# \, + \, Arc \, cotg \left[ CRw \left( \frac{L^2 \, w^2}{R^2} + 1 \right) \right].$$

Comme exemple de détermination des valeurs, on peut prendre le cas d'une surveillance d'une ligne d'énergie haute tension 127 kV 50 Hz à l'aide d'un pont capacitif réducteur de tension ayant une colonne capacitive de 4 000 pf d'une capacité de base de 10 µF aux bornes de laquelle est connecté un appareillage de mesure présentant une impédance d'entrée de 2 MΩ. On choisit un enroulement ayant une inductance de 10 H et une résistance de 1 890 Ω. Les conditions (1) et (2) deviennent :

$$\varepsilon = 15 \% \qquad LCw^2 = 9,87 .$$

L'assimilation, en régime permanent du dispositif à une inductance en série avec une résistance, présentant une forte impédance par rapport à la capacité de base est donc justifiée. On obtient sur le signal de mesure une erreur relative d'amplitude de l'ordre de 9 % et une erreur de phase de l'ordre de 3 degrés. Les charges piégées sont écoulées en une durée de 86 ms alors que, sans le dispositif il leur faudrait une vingtaine de secondes, durée qui est celle de la constante de temps de décharge d'une capacité de 10 µF dans une résistance de 2 MΩ.
Dans le cas où l'on désire des performances meilleures, c'est-à-dire un temps d'écoulement de

6

charges piégées très court, sans pour autant augmenter l'erreur relative d'amplitude et l'erreur d'angle de phase sur le signal de mesure, on peut ajouter, en parallèle sur tout ou partie des enroulements, des bobinages auxiliaires mis en service par des interrupteurs commandés qui s'ouvrent l'un après l'autre lorsque la tension élevée est rétablie. La figure 2 illustre un dispositif comportant un bobinage auxiliaire en parallèle sur chaque enroulement. Ce dispositif reprend la structure de celui de la figure 1, les éléments inchangés entre les deux figures ayant la même indexation. Chaque bobinage auxiliaire est représenté par une inductance 24 respectivement 25 en série avec une résistance 26 respectivement 27. Ils sont connectés chacun en parallèle avec une diode d'amortissement 28 respectivement 29 et en série avec un interrupteur commandé 33 respectivement 34 contrôlé par un circuit temporisateur 32 légèrement différent de celui 31 de la figure 1.

Le circuit temporisateur 32 est excité par le circuit détecteur de tension alternative 30. Il présente une triple temporisation, la première permettant de ne transmettre un ordre de fermeture aux interrupteurs commandés 19, 33 et 34, qu'après détection d'une coupure de la tension alternative élevée supérieure en durée à quelques secondes, par exemple cinq, la deuxième ne transmettant un ordre d'ouverture aux interrupteurs commandés 33 et 34 que quelques dizaines de millisecondes après la détection du rétablissement de la tension alternative élevée et la troisième ne transmettant un ordre d'ouverture de l'interrupteur commandé 19 qu'à une centaine de millisecondes après la détection du rétablissement de la tension alternative élevée.

Les diodes d'amortissement 28, 29 permettent au courant traversant les bobinages auxiliaires de s'amortir en se refermant sur eux-mêmes lors de l'ouverture des interrupteurs commandés 33, 34.

L'utilisation de bobinages auxiliaires mis en parallèle sur les enroulements et déconnectés progressivement au rétablissement de la tension alternative élevée permet de concilier l'exigence d'une faible valeur d'inductance nécessaire à l'écoulement rapide des charges piégées et celle d'une forte valeur d'inductance nécessaire pour réduire les perturbations apportées par le dispositif au signal de mesure. Le signal de mesure étant de toutes les façons perturbé pendant l'écoulement des charges piégées on peut admettre, pendant cet écoulement, un pourcentage d'erreur important. On ne peut cependant pas employer simplement le dispositif représenté à la figure 1 avec des enroulements à faible inductance car les perturbations qu'il apporte au signal de mesure provoquent lors de sa déconnexion par l'ouverture de l'interrupteur commandé 19, l'apparition de nouvelles charges piégées engendrant une saute de tension dans le signal de mesure pouvant avoir même amplitude relative que l'erreur de tension due au dispositif lui-même. Pour éviter cette nouvelle saute de tension, il faut alors augmenter l'inductance de l'enroulement par paliers en créant à chaque fois de nouvelles charges piégées en quantité de moins en moins importantes, absorbées par le dispositif lui-même jusqu'à ce que les perturbations apportées au signal de mesure par le dispositif soient, suffisamment faibles pour permettre la déconnexion du dispositif avec une saute de tension tolérable dans le signal de mesure.

On peut, sans sortir du cadre de l'invention modifier certaines dispositions ou remplacer certains moyens par des moyens équivalents. On peut par exemple placer davantage de bobinages auxiliaires mis en service par des interrupteurs commandés et échelonner dans le temps, lors du rétablissement de la tension alternative élevée, l'ouverture des interrupteurs commandés contrôlant les mises en service des bobinages auxiliaires connectés en parallèle sur un même enroulement afin d'obtenir une augmentation plus progressive de l'inductance. On peut également placer, entre les bornes alternatives du pont redresseur à diode 15, 16, 17, 18 un condensateur dont la capacité est calculée de manière à entrer en résonnance parallèle avec l'inductance équivalente du circuit formé par les enroulements 20, 22, 21, 23 et le pont redresseur à diodes 15, 16, 17, 18 à la fréquence de la tension alternative élevée. Grâce à lui l'impédance connectée aux bornes du condensateur de base 10 par l'intermédiaire de l'interrupteur commandé 19 est très grande et surtout le déphasage apporté très faible.

## Revendications

1. Dispositif pour l'élimination rapide des charges piégées dans un pont diviseur capacitif utilisé pour le contrôle d'une tension alternative élevée et formé d'une colonne capacitive (11) soumise à la quasi-totalité de la tension alternative élevée et d'une capacité de base (10) placée en série et ne supportant qu'une faible tension, ledit dispositif comportant une impédance de fuite connectée en parallèle sur la capacité de base, ledit dispositif étant caractérisé en ce que l'impédance de fuite comporte un pont redresseur à diodes (15, 16, 17, 18) connecté par ses bornes alternatives d'entrée en parallèle sur la capacité de base (10), et deux enroulements identiques (20, 22, 21, 23) connectés chacun en parallèle sur une diode (15, 16) du pont, les deux diodes (15, 16) shuntées par les enroulements étant directement raccordées à une même borne alternative du pont.

2. Dispositif selon la revendication 1, caractérisé en ce qu'il comporte en outre :
— un premier interrupteur commandé (19) intercalé en série avec le pont redresseur à diodes (15, 16, 17, 18) aux bornes de la capacité de la base (10),
— un circuit de détection de tension alternative (30) connecté aux bornes de la capacité de base (10)
— et un circuit de temporisation (31, 32) excité par le circuit de détection (30) et commandant la fermeture du premier interrupteur commandé (19) après détection par ledit circuit de détection (30) d'une coupure de la tension alternative durant plus de quelques secondes, et l'ouverture du premier interrupteur commandé (19) quelques dizaines de millisecondes après détection par ledit circuit de détection (30) d'un rétablissement de la tension alternative.

3. Dispositif selon la revendication 2, caractérisé en ce qu'il comporte en outre des bobinages auxiliaires (24, 26, 27, 28) connectés en parallèle sur tout ou partie desdits enroulements (20, 22, 21, 23) par l'intermédiaire de seconds interrupteurs commandés (33, 34) contrôlés par le circuit temporisateur (32) qui, après détection d'une coupure de la tension alternative durant plus de quelques secondes, en assure leurs fermetures en même temps que celle du premier interrupteur commandé (19) en série avec le pont redresseur à diodes (15, 16, 17, 18) et qui, après détection du rétablissement de la tension alternative, en assure leurs ouvertures plus précoces que celle du premier interrupteur commandé (19) en série avec le pont redresseur à diodes (15, 16, 17, 18).

4. Dispositif selon la revendication 3, caractérisé en ce que les ouvertures des seconds interrupteurs se font de manière échelonnée dans le temps.

5. Dispositif selon la revendication 1, caractérisé en ce qu'il comporte en outre un condensateur connecté entre les bornes alternatives du pont redresseur à diodes (15, 16, 17, 18) ledit condensateur ayant une capacité de valeur telle qu'il entre en résonance parallèle avec les enroulements (20, 21) par l'intermédiaire du pont redresseur à diodes (15, 16, 17, 18) à la fréquence de ladite tension alternative élevée.

## Claims

1. A circuit for rapidly eliminating charges trapped in a capacitor voltage divider used for monitoring high voltage AC and comprising a capacitor column (11) submitted to nearly the entire high voltage, and a base capacitor (10) connected in series therewith and supporting a low voltage only, that circuit comprising a shunt impedance disposed parallelly to the base capacitor, characterized in that the shunt impedance comprises a diode rectifier bridge (15, 16, 17, 18) connected by its AC input terminals in parallel to the base capacitor (10), and two identical windings (20, 22, 21, 23) connected in parallel respectively with one of the bridge diodes (15, 16), whereby these two diodes (15, 16) shunted by the windings are directly connected to the same one of the AC terminals of the bridge.

2. A circuit according to claim 1, characterized in that it further comprises :
— a first controlled switch (19) in series connection with the diode rectifier bridge (15, 16, 17, 18), this assembly being inserted between the terminals of the base capacitor (10),
— a circuit for detecting the AC voltage (30) connected to the terminals of the base capacitor (10),
— and a timing circuit (31 ; 32) which is excited by the detector circuit (30) and closes the first controlled switch (19) after having detected an AC voltage interruption of greater duration than some seconds, and opens said first controlled switch (19) some ten milliseconds after having detected the reestablishment of the AC voltage.

3. A circuit according to claim 2, characterized in that it further comprises auxiliary coils (24, 26, 27, 28) connected in parallel with at least a part of said windings (20, 22, 21, 23) via second controlled switches (33, 34), these switches being controlled by the timing circuit (32) in such a way that after detection of an interruption of the AC voltage for more than some seconds, closing of these switches is obtained simultaneously with the closing of the first controlled switch (19) which is connected in series with the diode rectifier bridge (15, 16, 17, 18), whereas their opening is obtained after detection of the reestablishment of the AC voltage at an earlier instant than the opening of the first controlled switch (19) which is connected in series with the diode rectifier bridge (15, 16, 17, 18).

4. A circuit according to claim 3, characterized in that the opening of the second switches is obtained in staggered intervals of time.

5. A circuit according to claim 1, characterized in that it further comprises a capacitor connected to the AC terminals of the diode rectifier bridge (15, 16, 17, 18) and having such a capacitance, that a parallel resonance oscillation is achieved together with the windings (20, 21) via the diode rectifier bridge (15, 16, 17, 18) at the frequency of said high AC voltage.

## Ansprüche

1. Schaltung zur schnellen Entfernung der in einer zur Überwachung hoher Wechselspannungen verwendeten kapazitiven Spannungsteilerbrücke gefangenen Ladungen, wobei die Brücke aus einer kapazitiven Säule (11), die praktisch der ganzen hohen Wechselspannung ausgesetzt ist, und aus einem in Reihe liegenden Basiskondensator (10) besteht, an dem nur eine niedrige Spannung liegt, und wobei die Schaltung eine Ableitimpedanz parallel zum Basiskondensator aufweist, dadurch gekennzeichnet, daß die Ableitimpedanz eine Dioden-Gleichrichterbrücke (15, 16, 17, 18), die mit ihren Wechseleingängen parallel zum Basiskondensator geschaltet ist, und zwei gleiche Spulen (20, 22, 21, 23) enthält, die je zu einer Diode (15, 16) der Brücke parallelgeschaltet sind, wobei diese Dioden, die von den Spulen überbrückt sind, direkt an einen gemeinsamen Wechselanschluß der Brücke angeschlossen sind.

2. Schaltung nach Anspruch 1, dadurch gekennzeichnet, daß sie außerdem aufweist :

— einen ersten gesteuerten Unterbrecher (19), der in Reihe mit der Diodengleichrichterbrücke (15, 16, 17, 18) an die Klemmen des Basiskondensators (10) angeschlossen ist,

— einen Schaltkreis (30) zur Wechselspannungsdetektion, der an die Klemmen des Basiskondensators (10) angeschlossen ist,

— und einen Verzögerungsschaltkreis (31 ; 32), der vom Detektorschaltkreis (30) angestoßen wird und das Schließen des ersten gesteuerten Unterbrechers (19) nach der Detektion einer länger als einige Sekunden dauernden Unterbrechung der Wechselspannung im Detektorschaltkreis (30) und das Öffnen des ersten gesteuerten Unterbrechers (19) einige zehn Millisekunden nach der Detektion des Wiederauftretens der Wechselspannung durch den Detektorschaltkreis (30) bewirkt.

3. Schaltung nach Anspruch 2, dadurch gekennzeichnet, daß sie außerdem Hilfsspulen (24, 26, 27, 28) enthält, die parallel zu einem Teil oder den ganzen erstgenannten Spulen (20, 22, 21, 23) über zweite gesteuerte Unterbrecher (33, 34) angeschlossen sind, wobei diese Unterbrecher vom Verzögerungsschaltkreis (32) gesteuert werden, der nach der Detektion einer Unterbrechung der Wechselspannung über mehr als einige Sekunden deren Schließen gleichzeitig mit dem des ersten gesteuerten Unterbrechers (19) in Reihe mit der Diodengleichrichterbrücke (15, 16, 17, 18) bewirkt und der nach der Detektion des Wiederauftretens der Wechselspannung deren Wiederöffnen zu einem Zeitpunkt bewirkt, der vor dem des Öffnens des ersten gesteuerten Unterbrechers (19) in Reihe mit der Diodengleichrichterbrücke (15, 16, 17, 18) liegt.

4. Schaltung nach Anspruch 3, dadurch gekennzeichnet, daß das Öffnen der zweiten Unterbrecher zeitlich nacheinander erfolgt.

5. Schaltung nach Anspruch 1, dadurch gekennzeichnet, daß sie außerdem einen Kondensator aufweist, der zwischen den Wechselspannungsklemmen der Diodengleichrichterbrücke (15, 16, 17, 18) liegt und einen solchen Kapazitätswert besitzt, daß er in Parallelresonanz mit den Spulen (20, 21) über die Diodengleichrichterbrücke (15, 16, 17, 18) bei der Frequenz der hohen Wechselspannung gelangt.

# FIG.1

# FIG.2